# EUROPÄISCHE PATENTSCHRIFT

(11) **EP 0 836 739 B1**
(45) Veröffentlichungstag und Bekanntmachung des Hinweises auf die Patenterteilung: **01.09.1999**
(21) Anmeldenummer: 96920716.6
(22) Anmeldetag: 20.06.1996
(51) Int. Cl.: G11C 16/06, G06F 9/445

(54) **VERFAHREN ZUM AKTUALISIEREN DES SPEICHERINHALTES EINES ELEKTRONISCHEN SPEICHERS EINES ELEKTRONISCHEN GERÄTES**
METHOD OF UP-DATING THE CONTENTS OF THE ELECTRONIC MEMORY OF AN ELECTRONIC APPLIANCE
PROCEDE POUR L'ACTUALISATION DU CONTENU DE LA MEMOIRE ELECTRONIQUE D'UN APPAREIL ELECTRONIQUE

(30) Priorität: 04.07.1995 DE 19525916
(43) Veröffentlichungstag der Anmeldung: 22.04.1998
(73) Patentinhaber: SIEMENS AKTIENGESELLSCHAFT, 80333 München (DE)
(72) Erfinder: KIND, Roland, D-10115 Berlin (DE); WESTERMANN, Frank, D-13629 Berlin (DE)
(86) Internationale Anmeldenummer: DE9601142
(87) Internationale Veröffentlichungsnummer: WO9702573

(56) Entgegenhaltungen:
- EP-A- 0 654 936
- FR-A- 2 531 800
- PATENT ABSTRACTS OF JAPAN vol. 16, no. 85 (P-1319), 28.Februar 1992 & JP,A,03 269633 (FUJITSU LTD), 2.Dezember 1991,
- IBM TECHNICAL DISCLOSURE BULLETIN, Bd. 37, Nr. 3, März 1994, NEW YORK US, Seite 503 XP000441560 "Method of updating microcode in a peripheral system"

## Beschreibung

Die Erfindung bezieht sich auf ein Verfahren zum Aktualisieren des Speicherinhaltes eines elektronischen Speichers eines elektronischen Gerätes, der als löschbarer Festwert-Speicherbaustein ausgebildet ist und den Programm-Code des elektronischen Gerätes enthält,
- bei dem von einer über eine serielle Schnittstelle mit dem elektronischen Gerät verbundenen Datenverarbeitungsanlage mit dem aktuellen Speicherinhalt in ihrem Speicher der aktuelle Speicherinhalt in den löschbaren Festwert-Speicherbaustein des elektronischen Gerätes übertragen wird.

Ein derartiges Verfahren ist dem "IBM Technical Disclosure Bulletin" Vol. 37, No. 03, März 1994, S. 503 entnehmbar. Bei diesem bekannten Verfahren wird ein zusätzlicher löschbarer Festwert-Speicherbaustein verwendet, von dem zum Aktualisieren des Speicherinhaltes des einen löschbaren Festwert-Speicherbausteins eine Kommunikationsaufnahme mit einer verbundenen Datenverarbeitungsanlage erfolgt. Anschließend wird ein neuer Programm-Code über den zusätzlichen Festwert-Speicherbaustein in einen großen Buffer geladen (bei dem es sich um ein RAM handeln könnte) und auch ein Löschen des einen Festwert-Speicherbausteins vorgenommen. Danach wird der neue Programm-Code aus dem großen Buffer in den einen Festwert-Speicherbaustein geladen.

Der Erfindung liegt die Aufgabe zugrunde, ein Verfahren zum Aktualisieren des Speicherinhaltes eines elektronischen Speichers vorzuschlagen, mit dem auch der Speicherinhalt eines als löschbarer Festwert-Speicherbaustein ausgebildeten elektronischen Speichers eines elektronischen Gerätes aktualisiert werden kann.

Zur Lösung dieser Aufgabe wird bei einem Verfahren der eingangs angegebenen Art erfindungsgemäß in einen dem löschbaren Festwert-Speicherbaustein zugeordneten Speicher mit wahlfreiem Zugriff des elektronischen Gerätes von der Datenverarbeitungsanlage ein dem Programm-Code entsprechender Programm-Code geladen, und der in den Speicher mit wahlfreiem Zugriff geladene Programm-Code wird aktiviert, wodurch eine Kommunikationsaufnahme zwischen diesem Speicher und der Datenverarbeitungsanlage vorgenommen wird; durch die Kommunikationsaufnahme wird ein Löschen des löschbaren Festwert-Speicherbausteins vorgenommen, der aktuelle Speicherinhalt wird aus dem Speicher der Datenverarbeitungsanlage in den löschbaren Festwert-Speicherbaustein geladen und von der Datenverarbeitungsanlage wird ein RESET veranlaßt.

Ein wesentlicher Vorteil des erfindungsgemäßen Verfahrens besteht darin, daß mit ihm löschbare Festwert-Speicherbausteine hinsichtlich ihres Speicherinhaltes auch dann aktualisiert werden können, wenn sie mit dem Programm-Code oder einem Teil des Programm-Codes des elektronischen Gerätes geladen sind. Dabei bedarf es eines Austausches des jeweiligen löschbaren Festwert-Speicherbausteins in dem elektronischen Gerät nicht; auch andere hardwaremäßige Maßnahme zum Aktualisieren des Speicherinhaltes sind bei dem erfindungsgemäßen Verfahren nicht erforderlich.

Bei einer besonders vorteilhaften Form des erfindungsgemäßen Verfahrens wird als löschbarer Festwert-Speicherbaustein ein EPROM mit mindestens einem von einer Löschung ausschließbaren Bereich verwendet, und die Kommunikationsaufnahme zwischen dem EPROM und der Datenverarbeitungsanlage erfolgt mittels eines Programm-Teils, das in dem von einer Löschung ausschließbaren Bereich des EPROMS gespeichert ist.

Der Vorzug dieses Verfahrens besteht darin, daß in einem Zustand, in dem das EPROM bereits gelöscht ist und durch beispielsweise Spannungsausfall auch das RAM entladen ist, eine Kommunikation von dem elektronischen Gerät bzw. dem EPROM zur Datenverarbeitungsanlage mit Hilfe des in dem von einer Löschung ausschließbaren Bereich gespeicherten Programm-Teils hergestellt werden kann, so daß das Verfahren des Aktualisierens des Speicherinhaltes des EPROM auch in dem geschilderten Zustand der Speicher des elektronischen Gerätes ohne weiteres erneut begonnen werden kann.

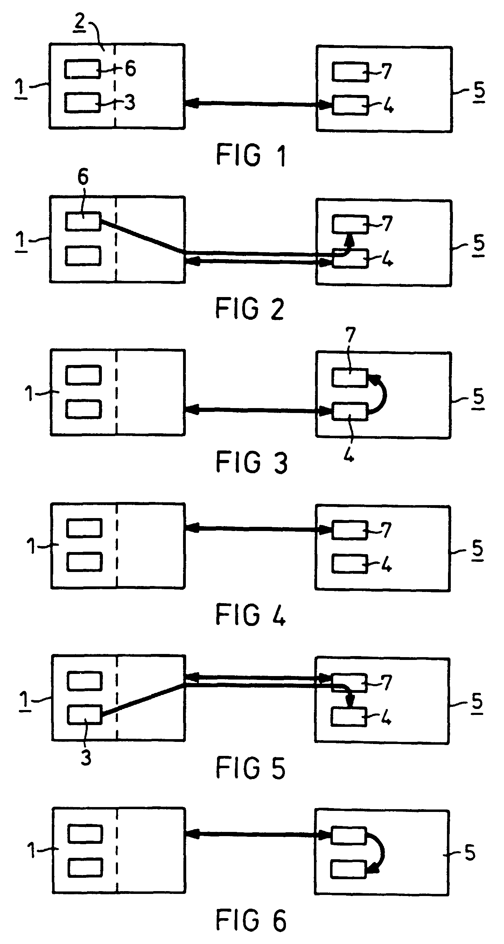

Zur Erläuterung der Erfindung ist in den Figuren 1 bis 6 der Ablauf des erfindungsgemäßen Verfahrens symbolisch dargestellt.

Die Figur 1 zeigt als Datenverarbeitungsanlage einen Personalcomputer 1, in dessen Speicherbereich 2 unter anderem ein Code 3 geladen ist, der zur Neuprogrammierung eines als Flash-EPROM ausgebildeten löschbaren Festwert-Speicherbausteins 4 eines elektronischen Gerätes 5 vorgesehen ist; bei dem elektronischen Gerät 5 kann es sich beispielsweise um ein Gerät der Schutztechnik zum Erfassen von Fehlern in elektronischen Energieversorgungseinrichtungen handeln.Der Speicherbereich 2 des Personalcomputers 1 enthält ferner einen Speicher 6 mit wahlfreiem Zugriff (RAM). Auch das elektronische Gerät 5 ist mit einem RAM 7 ausgerüstet.Die übrigen elektronischen Teile des elektronischen Gerätes 5, wie beispielsweise ein Prozessor, sind in der Figur 1 und auch in den folgenden Figuren nicht dargestellt.

Zu dem in Figur 1 dargestellten Beginn des Ablaufs des erfindungsgemäßen Verfahrens ist eine Kommunikationsaufnahme zwischen dem Personalcomputer 1 und dem löschbaren Festwert-Speicherbaustein 4 des elektronischen Gerätes 5 eingeleitet, bei der unter anderem eine Identifizierung des elektronischen Gerätes 5 und eine Einstellung der Baudrate erfolgt.

Die Figur 2 veranschaulicht, daß in einem nächsten Verfahrensschritt nach der Kommunikationsaufnahme aus dem RAM 6 des Personalcomputers 1 in das RAM 7 des elektronischen Gerätes 5 ein Programm-Code geladen wird, der die Befehle für das Ablauf-Programm des elektronischen Gerätes 5 beinhaltet. Außerdem erfolgt ein Check.

Figur 3 zeigt, daß nach dem Laden des Programm-Codes aus dem RAM 6 des Personal computers 1 in das RAM 7 des elektronischen Gerätes 5 der Code im RAM 7 aktiviert wird. Daraufhin erfolgt - wie Figur 4 zeigt - eine Kommunikationsaufnahme zwischen dem RAM 7 des elektronischen Gerätes 5 und dem Personalcomputer 1, in dessen Verlauf unter anderem überprüft wird, ob das RAM 7 des Gerätes 5 ordnungsgemäß geladen worden ist. Ist dies gegeben, dann erfolgt ein Löschen des Speicherinhalts des EPROM 4 des elektronischen Gerätes 5.

Anschließend wird - wie Figur 5 veranschaulicht - der aktuelle Speicherinhalt bzw. Code 3 aus dem Personalcomputer 1 in das EPROM 4 des elektronischen Gerätes 5 geladen, wodurch der Speicherinhalt des elektronischen Gerätes 5 bezüglich des EPROM 4 aktualisiert ist.

Schließlich folgt - wie Figur 6 zeigt - ein Befehl seitens des Personalcomputers 1, wodurch mittels eines Reset der Aktualisierungsvorgang abgeschlossen wird.

## Patentansprüche

1. Verfahren zum Aktualisieren des Speicherinhaltes eines elektronischen Speichers (4) eines elektronischen Gerätes (5), der als löschbarer Festwert-Speicherbaustein ausgebildet ist und den Programm-Code des elektronischen Gerätes (5) enthält,
- bei dem von einer über eine serielle Schnittstelle mit dem elektronischen Gerät verbundenen Datenverarbeitungsanlage (1) mit dem aktuellen Speicherinhalt in ihrem Speicher der aktuelle Speicherinhalt in den löschbaren Festwert-Speicherbaustein des elektronischen Gerätes übertragen wird,
**dadurch gekennzeichnet**, daß
- in einen dem löschbaren Festwert-Speicherbaustein (4) zugeordneten Speicher (7) mit wahlfreiem Zugriff des elektronischen Gerätes (5) von der Datenverarbeitungsanlage (1) ein dem Programm-Code entsprechender Programm-Code (6) geladen wird,
- der in den Speicher mit wahlfreiem Zugriff (7) geladene Programm-Code (6) aktiviert wird, wodurch eine Kommunikationsaufnahme zwischen diesem Speicher (7) und der Datenverarbeitungsanlage (1) vorgenommen wird,
- durch die Kommunikationsaufnahme ein Löschen des löschbaren Festwert-Speicherbausteins (4) vorgenommen wird,
- der aktuelle Speicherinhalt aus dem Speicher (2) der Datenverarbeitungsanlage (1) in den löschbaren Festwert-Speicherbaustein(4) geladen wird und
- von der Datenverarbeitungsanlage (1) ein RESET veranlaßt wird.

2. Verfahren nach Anspruch 1,
**dadurch gekennzeichnet**, daß
- als löschbarer Festwert-Speicherbaustein ein EPROM mit mindestens einem von einer Löschung ausschließbaren Bereich verwendet wird und
- die Kommunikationsaufnahme zwischen dem EPROM und der Datenverarbeitungsanlage mittels eines Programm-Teils erfolgt, das in dem von einer Löschung ausschließbaren Bereich des EPROMS gespeichert ist.

## Claims

1. Method for updating the memory contents of an electronic memory (4) of an electronic apparatus (5), which is constructed as an erasable read-only memory module and contains the program code of the electronic apparatus (5)
- in which method a data-processing unit (1), which is connected by way of a serial interface to the electronic apparatus and has the current memory contents in its memory, transmits the current memory contents into the erasable read-only memory module of the electronic apparatus,
characterised in that
- a program code (6) corresponding to the program code is loaded by the data-processing unit (1) into a random access memory (7) of the electronic apparatus (5) that is allocated to the erasable read-only memory module (4),
- the program code (6) loaded into the random access memory (7) is activated, as a result of which a communication pick-up between this memory (7) and the data-processing unit (1) is carried out,
- by means of the communication pick-up, an erasure of the erasable read-only memory module (4) is carried out,
- the current memory contents are loaded from the memory (2) of the data-processing unit (1) into the erasable read-only memory module (4), and
- the data-processing unit (1) effects a RESET.

2. Method according to claim 1,
characterised in that
- there is used as an erasable read-only memory module an EPROM having at least one area which can be excluded from an erasure, and
- the communication pick-up between the EPROM and the data-processing unit takes place by means of a program part which is stored in the area of the EPROM that can be excluded from an erasure.

## Revendications

1. Procédé de mise à jour du contenu de mémoire d'une mémoire (4) électronique d'un appareil (5) électronique qui est réalisée en module de mémorisation à mémoire morte effaçable et qui contient le code programme de l'appareil (5) électronique,
- dans lequel il est transmis par une installation (1) de traitement de données, reliée à l'appareil électronique par l'intermédiaire d'une interface sérielle et comportant le contenu de mémoire instantanée dans sa mémoire, le contenu de mémoire instantanée au module de mémorisation à mémoire morte effaçable de l'appareil électronique,
caractérisé en ce que
- un code (6) programme correspondant au code programme est chargé par l'installation (1) de traitement de données dans une mémoire (7) à accès sélectif, associée au module (4) de mémorisation à mémoire morte effaçable, de l'appareil (5) électronique,
- le code (6) programme chargé dans la mémoire (7) à accès sélectif est activé, ce qui fait qu'il s'effectue une prise de communication entre cette mémoire (7) et l'installation (1) de traitement de données,
- un effaçage du module (4) de mémorisation à mémoire morte effaçable est effectué par la prise de communication,
- le contenu de mémoire instantané est chargé de la mémoire (2) de l'installation (1) de traitement de données dans le module (4) de mémorisation à mémoire morte effaçable et
- un RESET est provoqué par l'installation (1) de traitement de données.

2. Procédé suivant la revendication 1, caractérisé en ce que
- on utilise comme module de mémorisation à mémoire morte effaçable une EPROM ayant au moins une zone pouvant être exclue d'un effaçage et
- la prise de communication entre l'EPROM et l'installation de traitement de données s'effectue au moyen d'une partie de programme qui est mémorisée dans la zone de l'EPROM qui peut être exclue d'un effaçage.
